# EUROPEAN PATENT SPECIFICATION

(11) **EP 0 557 207 B1**
(45) Date of publication and mention of the grant of the patent: **03.05.2000**
(21) Application number: 93400442.5
(22) Date of filing: 19.02.1993
(51) Int. Cl.: H01L 39/22, H01L 39/24

(54) **Josephson junction device of oxide superconductor and process for preparing the same**
Josephson-Übergangseinrichtung aus oxidischem Supraleiter und Verfahren zu ihrer Herstellung
Dispositif à jonction de type Josephson à supraconducteur d'oxyde et procédé de préparation

(30) Priority: 19.02.1992 JP 6951192; 19.02.1992 JP 6951292
(43) Date of publication of application: 25.08.1993
(73) Proprietor: Sumitomo Electric Industries, Ltd., Osaka 541 (JP)
(72) Inventor: Tanaka, Saburo, c/o Itami Works of, Itami-shi, Hyogo (JP); Matsuura, Takashi, c/o Itami Works of, Itami-shi, Hyogo (JP); Itozaki, Hideo, c/o Itami Works of, Itami-shi, Hyogo (JP)
(74) Representative: Obolensky, Michel

(56) References cited:
- EP-A- 0 493 258
- EP-A- 0 502 787
- EP-A- 0 524 862
- WO-A-92/15406
- APPLIED PHYSICS LETTERS vol. 59, no. 6, 5 August 1991, NEW YORK, US pages 733 - 735 K.Char et al 'Bi-epitaxial grain boundary junctions in YBa2Cu3O7'
- APPLIED PHYSICS LETTERS vol. 57, no. 7, 13 August 1990, NEW YORK, US pages 727 - 729 R.Gross et al 'Low noise YBa2Cu3O7-x grain boundary junction dc SQUIDs'

## Description

### Background of the Invention

### Field of the invention

The present invention relates to a Josephson junction device of an oxide superconductor and a process for preparing the Josephson junction device, and more specifically to a Josephson junction device of an oxide superconductor, of which the tunnel barrier is constituted of a grain boundary of two single crystal oxide superconductor regions and a process for preparing the Josephson junction device.

### Description of related art

A Josephson junction which is one of superconducting junctions can be realized in various structures. Among the various structures, the most preferable structure in practice is a stacked junction realized by a thin non-superconductor layer sandwiched between a pair of superconductors. However, a point contact type junction, a Dayem bridge type junction and a variable thickness bridge type junction which are composed of a pair of superconductor regions which are weakly linked to each other also exhibit Josephson effect. In general, these Josephson junctions have fine structures in which the superconductor and non-superconductor are composed of thin films.

In order to realize a stacked type junction by using an oxide superconductor, a first oxide superconductor thin film, a non-superconductor thin film and a second oxide superconductor thin film are stacked on a substrate in the named order.

In the above mentioned stacked type junction, an insulator MgO etc., a semiconductor Si etc., and a metal Au etc. are used for the non-superconductor layers of different applications so that each superconducting junction has different properties.

The thickness of the non-superconductor layer of the stacked type junction is determined by the coherence length of the superconductor. In general, the thickness of the non-superconductor layer of the stacked type junction must be within a few times of the coherence length of the superconductor. On the other hand, since oxide superconductor materials have a very short coherence length, therefore, a thickness of a non-superconductor layer must be about a few nanometers.

However, the superconductor layers and the non-superconductor layer of the stacked type junction must be of high crystallinity for favorable junction properties, which are composed of single crystals or composed of polycrystals which are oriented in almost same direction. It is difficult to stack an extremely thin and high crystalline non-superconductor layer on an oxide superconductor layer. Additionally, it is very difficult to stack a high crystalline oxide superconductor layer on the non-superconductor layer stacked on an oxide superconductor layer. Though the stacked structure including a first oxide superconductor layer, a non-superconductor layer and a second oxide superconductor layer is realized, the interfaces between the oxide superconductor layers and the non-superconductor layer are not in good condition so that the stacked type junction does not function in good order.

In order to manufacture a point contact type junction, a Dayem bridge type junction and a variable thickness bridge type junction by using oxide superconductor, very fine processings which realize a weak link of a pair of superconductor are necessary. It is very difficult to conduct a fine processing with good repeatability.

The point contact type junction has been formed of two oxide superconductor thin films which are in contact with each other in a extremely small area which constitutes the weak link of the Josephson junction.

The Dayem bridge type junction has been formed of a constant thickness oxide superconductor thin film which is formed on a substrate and which is patterned in a plan view, so that a superconductor thin film region having a greatly narrow width is formed between a pair of superconductor thin film regions having a sufficient width. In other words, the pair of superconductor thin film regions having a sufficient width are coupled to each other by the superconductor thin film region having the greatly narrow width. Namely, a weak link of the Josephson junction in the superconductor thin film is formed at the greatly narrow width region.

On the other hand, the variable thickness bridge type junction has been formed of an oxide superconductor thin film of a sufficient thickness which is formed on a substrate and which is partially etched or thinned in a thickness direction, so that a thinned oxide superconductor thin film portion is formed between a pair of superconductor thin film portions having the sufficient thickness. In other words, the pair of superconductor thin film portions having the sufficient thickness are coupled to each other by the thinned oxide superconductor thin film portion. Accordingly, a weak link of the Josephson junction is formed at the reduced thickness portion of the oxide superconductor thin film.

As would be understood from the above, a characteristics of the Josephson junction device has a close relation to the contact area of the superconductor thin film in the point contact type Josephson junction device, the width of the superconductor thin film region having the greatly narrow width in the Dayem bridge type Josephson junction device, and to the thickness of the thinned oxide superconductor thin film portion in the variable thickness bridge type Josephson junction device, both of which form the weak link of the Josephson junction. Therefore, in order to obtain a desired characteristics with a good repeatability, a high precision on a sub-micron level of the processing such as the etching is required.

The Dayem bridge type Josephson junction device can be said to be more preferable than the variable thickness bridge type Josephson junction device, since the Dayem bridge type Josephson junction device has a relatively planer surface, which is preferred in a integrated circuit. However, in order to form the weak link in the Dayem bridge type Josephson junction device, it is required to pattern an oxide superconductor thin film having the thickness on the order of 0.5 µm to 1.0 µm into a width of not greater than 0.2 µm. However, it is very difficult to conduct this fine patterning with good repeatability.

On the other hand, in the variable thickness bridge type Josephson junction device, the very fine pattering is not required in order to form the weak link. However, it is very difficult to uniformly control the remaining thickness of the thinned portion forming the weark link. In addition, the variable thickness bridge type Josephson junction device cannot have a satisfactorily planer surface. This is not preferable to the integrated circuit application.

It is known from APPLIED PHYSICS LETTERS, vol.59, n° 6, August 5, 1991, NEW YORK, US, pages 733-735 a bi-epitaxial grain boundary junction in YBa₂Cu₃O₇. A SQUID device comprising a substrate, a MgO seed layer and grain boundary junctions is disclosed in this reference.

EP-A-0 502 787 concerns a thin film of oxide superconductor possessing locally different crystal orientations and processes for preparing the same.

However, the device of this second reference is not a Josephson junction.

WO-A-9 215 496 concerns devices from and method for producing crystallographic boundary junctions in superconducting thin films.

This device utilizes a V-groove or a step of a substrate "step edge junctions device".

Therefore, in the prior art, it is almost impossible to manufacture a superconducting device for example a dc SQUID (superconducting quantum interference device) which has multiple homogeneous Josephson junctions by using an oxide superconductor.

### Summary of the Invention

Accordingly, it is an object of the present invention to provide a Josephson junction device including a weak link of the Josephson junction composed of an oxide superconductor material and planar surface, which have overcome the above mentioned defects of the conventional ones.

Another object of the present invention is to provide a method for manufacturing a Josephson junction device with good repeatability by using existing established processing techniques.

The above and other objects of the present invention are achieved in accordance with the present invention by a Josephson junction device comprising a substrate and an oxide superconductor thin film formed on a principal surface of the substrate, characterized in that the principal surface of the substrate is uniform and planar and the oxide superconductor thin film comprises two portions constituted of single crystals of Y₁Ba₂Cu₃O_{7-δ} superconductor, one of which is composed of a-axis orientated single crystal of Y₁Ba₂Cu₃O_{7-δ} superconductor and the other of which is composed of c-axis orientated single crystal of Y₁Ba₂Cu₃O_{7-δ} superconductor, each portion being formed on the principal surface of the substrate, and a grain boundary between said two portions, which constitutes a weak link of the Josephson junction.

The Josephson junction device includes an oxide thin film formed on a portion of the principal surface of the substrate, which is constituted of a single crystal which has a similar crystal structure to that of an *a*-axis orientated oxide superconductor crystal or a *c*-axis orientated oxide superconductor crystal, on which one of said two portions of the oxide superconductor thin film is formed and the other portion of the superconductor thin film is formed on the principal surface of the substrate directly so that the crystal directions of said two portions of the oxide superconductor thin film are respectively epitaxial to those of the oxide thin film and the principal surface of the substrate and the grain boundary which constitutes a weak link of the Josephson junction is formed just on the edge portion formed of the oxide thin film.

As discussed in detail later, the oxide thin film is a so-called seed thin film.

The oxide superconductor thin film includes two apart portions between said two portions, each of which includes the grain boundary which constitutes the weak link of the Josephson junction.

The oxide superconductor thin film is formed in an annular shape which includes two apart portions each of which includes the grain boundary which constitutes the weak link of Josephson junction. In this case, the Josephson junction device constitutes a dc SQUID.

In order to stabilize the Josephson junction properties of the Josephson junction device in accordance with the present invention, it is effective to narrow the portion of the oxide superconductor thin film, in which the grain boundary is formed, so as to have a narrower width than other portions. Preferably, the narrow portion of the oxide superconductor thin film has a width of 1.5 to 15 µm and a length of 5 to 50 µm. The width of the narrow portion of the oxide superconductor thin film of the Josephson junction device in accordance with the present invention is far larger than that of the greatly narrow bridge of a conventional Dayem bridge type Josephson junction device. Therefore, it is possible to relax the limitation in the fine processing techniques such as a fine-etching or a fine-patterning which has been required in the case that conventional Dayem bridge type Josephson junction device.

The seed oxide thin film is formed of Y₁Ba₂Cu₃O_{7-δ.} It is easy to deposit *a*-axis orientated thin films or *c*-axis orientated thin films of this oxide on a single crystal oxide substrate such as a MgO (100) substrate, a SrTiO₃ (110) substrate, an yttrium stabilized zirconia (YSZ) substrate, etc., by keeping suitable substrate temperatures while the thin films grow.

On the other hand, the oxide superconductor thin film deposited on the seed oxide thin film grows eptaxially, even if the condition is not completely suitable.

For this effect, the seed oxide thin film needs high crystallinity and preferably has a thickness of 2 to 10 nanometers. If the thickness of the oxide thin film is less than 2 nanometer, the oxide grows in the form of cluster or in the form of a film of poor crystallinity. If the thickness of the oxide thin film exceeds 10 nanometer, a step is generated clearly on the upper surface of the oxide superconductor thin film, which prevent from composing a planar type device.

In addition, the substrate can be formed of a single crystal oxide substrate such as a MgO (100) substrate, a SrTiO₃ (110) substrate, an yttrium stabilized zirconia (YSZ) substrate, etc.

According to another aspect of the present invention, there is provided a process of manufacturing a Josephson junction device as defined in claim 7.

The process can include a step of narrowing a portion of the oxide superconductor thin film, which crosses the edge portion of the oxide thin film by a reactive ion etching process.

In a preferred embodiment, the oxide superconductor thin film is formed by using a silicone plate mask so that the oxide superconductor thin film is shaped so as to include two apart potions crossing the edge portion of the oxide thin film, each of which includes the grain boundary which constitutes the weak link of the Josephson junction. In this case, the oxide superconductor thin film can be shaped into an annular shape which includes two apart potions crossing the edge portion of the oxide thin film, each of which includes the grain boundary which constitutes the weak link of the Josephson junction.

The above and other objects, features and advantages of the present invention will be apparent from the following description of preferred embodiments of the invention with reference to the accompanying drawings.

### Brief Description of the Drawings

Figures 1A to 1C are diagrammatic views for illustrating one embodiment of the process for manufacturing the Josephson device in accordance with the present invention, in that Figures 1A and 1B show diagrammatic sectional views, Figure 1BB shows a plane view of Figure 1B, and Figure 1C shows a diagrammatic plane view;
Figures 2 is a diagrammatic plane view of a preferred embodiment of the dc SQUID in accordance with the present invention;
Figures 3A to 3C are diagrammatic views for illustrating another embodiment of the process for manufacturing the Josephson device in accordance with the present invention, in that Figures 3A and 3B show diagrammatic sectional views, Figure 3BB shows a plane view of Figure 3B, and Figure 3C shows a diagrammatic plane view;
Figures 4 is a diagrammatic plane view of another preferred embodiment of the dc SQUID in accordance with the present invention; and
Figures 5 is a graph of the output voltage against the magnetic field for the dc SQUIDs shown in Figures 2 and 4.

### Description of the Preferred embodiments

### Embodiment 1

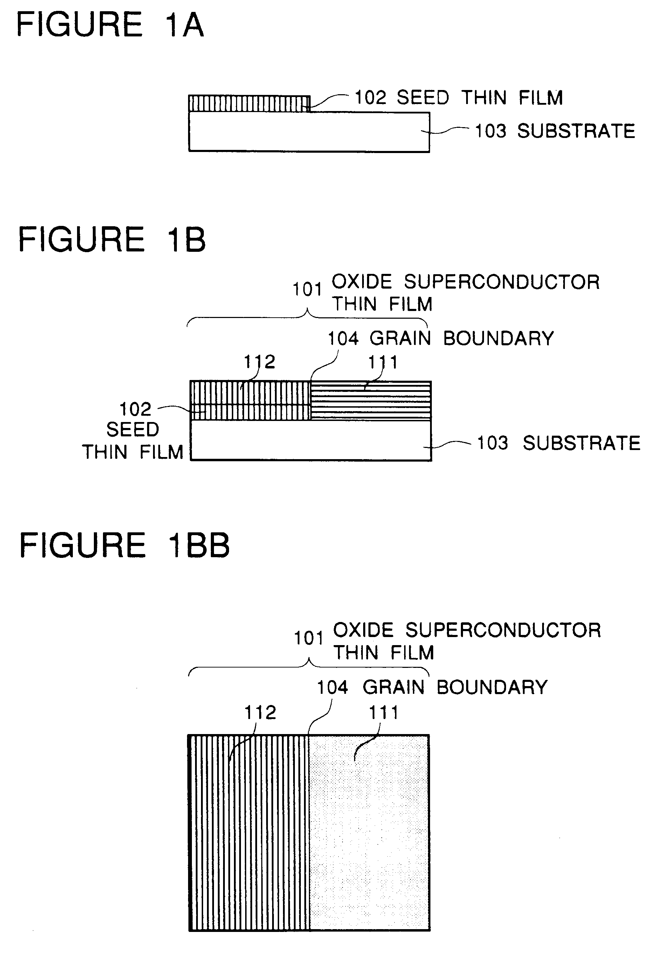

Referring to Figures 1A to 1C, the process in accordance with the present invention for manufacturing the Josephson junction device will be described.

As shown in Figure 1A, a seed thin film 102 of an *a*-axis orientated Y₁Ba₂Cu₃O_{7-δ} single crystal having a thickness of 5 nanometers was deposited on the left half of the surface of a MgO (100) single crystal substrate 103 by a sputtering process. The condition of the sputtering process was as follows;

| | | |
|---|---|---|
| Temperature of substrate | | 570°C |
| Sputtering gases | A r | 8 sccm |
| | O₂ | 4 sccm |
| Pressure | | 6.665 Pa (5x10⁻² Torr) |

The seed thin film 102 is a thin film on which an *a*-axis orientated Y₁Ba₂Cu₃O_{7-δ} thin film will grow epitaxially, even if the Y₁Ba₂Cu₃O_{7-δ} thin film is deposited under a condition under which a *c*-axis orientated Y₁Ba₂Cu₃O_{7-δ} thin film grows on the substrate. Therefore, the seed thin film 102 of *a*-axis orientated Y₁Ba₂Cu₃O_{7-δ} single crystal is not necessary to be superconducting, if it has high crystallinity. In this connection, an *a*-axis orientated Y₁Ba₂Cu₃O_{7-δ} thin film can be deposited by a sputtering process under a substrate temperature 560 to 580 °C or by a laser ablation process under a substrate temperature 580 to 620 °C.

Then, as shown in Figure 1B, a Y₁Ba₂Cu₃O_{7-δ} oxide superconductor thin film 101 having a thickness of 300 nanometers was deposited on the seed thin film 102 and the exposing right half of the surface of the MgO (100) single crystal substrate 103 by a sputtering process. The sputtering process was carried out under a condition under which a *c*-axis orientated Y₁Ba₂Cu₃O_{7-δ} oxide superconductor thin film grew on the surface of the MgO (100) single crystal substrate 103. The condition of the sputtering process was as follows;

| | | |
|---|---|---|
| Temperature of substrate | | 620°C |
| Sputtering gases | Ar | 8 sccm |
| | O₂ | 4 sccm |
| Pressure | | 6.665 Pa (5x10⁻² Torr) |

A *c*-axis orientated Y₁Ba₂Cu₃O_{7-δ} thin film can be deposited by a sputtering process under a substrate temperature 590 to 650 °C or by a laser ablation process under a substrate temperature 630 to 700 °C.

A portion 112 of the Y₁Ba₂Cu₃O_{7-δ} oxide superconductor thin film 101 on the seed thin film 102 grew epitaxially to the seed thin film 102 and the other portion 111 of the Y₁Ba₂Cu₃O_{7-δ} oxide superconductor thin film 101 on the surface of MgO substrate 103 became *c*-axis orientated. Therefore, as shown in Figure 1BB, the portion 112 of the Y₁Ba₂Cu₃O_{7-δ} oxide superconductor thin film 101, which grew on the seed thin film 102 was composed of an *a*-axis orientated Y₁Ba₂Cu₃O_{7-δ} oxide superconductor thin film and the portion 111 of the Y₁Ba₂Cu₃O_{7-δ} oxide superconductor thin film 101, which grew directly on the surface of MgO substrate 103 was composed of a *c*-axis orientated Y₁Ba₂Cu₃O_{7-δ} oxide superconductor thin film. A grain boundary 104 was created on the interface between the portions 111 and 112, which was just on the edge of the seed thin film 102. The grain boundary 104 formed a weak link of a Josephson junction.

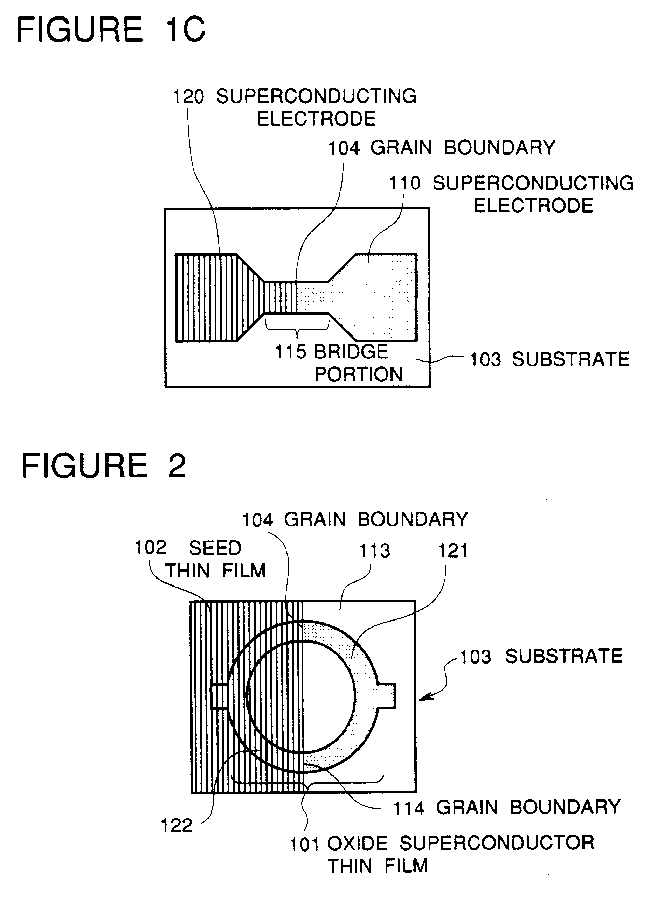

Finally, as shown in Figure 1C, the Y₁Ba₂Cu₃O_{7-δ} oxide superconductor thin film 101 was processed by a reactive ion etching process so that a bridge portion 115 having a length of 10 µm and a width of 5 µm, on the center portion of which the grain boundary 104 was positioned, was created between superconducting electrodes 110 and 120 having a sufficient width. The width of the bridge portion 115 was not so narrow as that of a conventional Dayem bridge type Josephson junction device.

Thus, the Josephson junction device as shown in Figure 1C was completed. The Josephson junction device manufactured by the method in accordance with the present invention was constituted of an oxide superconductor thin film which had a planar surface and a bridge portion 115 having a narrow width between two superconducting electrodes 110 and 120 having a sufficient width. The lattice orientations of two superconducting electrodes 110 and 120 were different from each other so that the two superconducting electrodes 110 and 120 were weakly linked by the grain boundary 104 in the bridge portion 115, which constituted the superconducting barrier of the Josephson junction.

A current-voltage characteristics of the above mentioned Josephson junction device was measured at a temperature of 85K. When a microwave of 15 GHz and of 0.2 mW was irradiated, clear Shapiro steps of was observed at multiple voltages of 31 µV, and therefore, it could be ascertained that the Josephson junction was realized in the device.

As explained above, if the above mentioned Josephson junction device is manufactured in accordance with the above mentioned process, the limitation in the fine processing technique required for manufacturing the Josephson junction device is relaxed. In addition, since the superconducting barrier is constituted of the grain boundary, it become easy to form the superconducting barrier sharply. Accordingly, it is easy to manufacture the Josephson junction device with good repeatability, and the manufactured Josephson junction device has a stable performance.

### Embodiment 2

Referring to Figure 2, there is shown a diagrammatic plane view of another embodiment of the Josephson junction device in accordance with the present invention. The Josephson junction device shown in this embodiment is a dc SQUID.

The dc SQUID includes a MgO (100) substrate 103, a a seed thin film 102 of an *a*-axis orientated Y₁Ba₂Cu₃O_{7-δ} single crystal, deposited on the left half of the surface of the MgO substrate 103 and an annular shaped Y₁Ba₂Cu₃O_{7-δ} oxide superconductor thin film 101 formed on the MgO substrate 103 and the seed thin film 102. The Y₁Ba₂Cu₃O_{7-δ} oxide superconductor thin film 101 is formed an annular ring shape which crosses an edge of the seed thin film 102 at two portions.

The portions 122 and 121 of the Y₁Ba₂Cu₃O_{7-δ} oxide superconductor thin film 101 are formed epitaxially to the seed thin film 102 and MgO substrate 103. Therefore, the portion 122 of the Y₁Ba₂Cu₃O_{7-δ} oxide superconductor thin film 101, which grew on the seed thin film 102 is composed of an *a*-axis orientated Y₁Ba₂Cu₃O_{7-δ} oxide superconductor thin film and the portion 121 of the Y₁Ba₂Cu₃O_{7-δ} oxide superconductor thin film 101, which grew directly on the surface 113 of MgO substrate 103 is composed of a *c*-axis orientated Y₁Ba₂Cu₃O_{7-δ} oxide superconductor thin film.

Grain boundaries 104 and 114 are formed on the interfaces between the portions 121 and 122 of the Y₁Ba₂Cu₃O_{7-δ} oxide superconductor thin film 101 just on the edge of the seed thin film 102. The grain boundaries 104 and 114 form weak links of a Josephson junction.

The above mentioned dc SQUID was manufactured by the following method in accordance with the present invention. At first, a seed thin film 102 of an *a*-axis orientated Y₁Ba₂Cu₃O_{7-δ} single crystal having a thickness of 5 nanometers was deposited on the left half of the surface of a MgO (100) single crystal substrate 103 by a laser ablation process. The condition of the laser ablation was as follows:

| | | |
|---|---|---|
| Temperature of substrate | | 600°C |

| O₂ atmosphere | | |
|---|---|---|
| Pressure | | 13.33 Pa (0.1 Torr) |
| Excimer laser | wave length | 193 nanometers |
| | energy density | 2 Joule/cm² |
| | pulse rate | 5 Hz |

Then, an annular shaped Y₁Ba₂Cu₃O_{7-δ} oxide superconductor thin film 101 having a thickness of 300 nanometers was deposited on the seed thin film 102 and the exposing right half of the surface 113 of each of the MgO (100) substrate 103 by a laser ablation process in which patterned silicone plate was used as a mask. The condition of the laser ablation was as follows:

| | | |
|---|---|---|
| Temperature of substrate | | 650°C |

| O₂ atmosphere | | |
|---|---|---|
| Pressure | | 13.33 Pa (0.1 Torr) |
| Excimer laser | wave length | 193 nanometers |
| | energy density | 2 Joule/cm² |
| | pulse rate | 5 Hz |

As mentioned above, the portion 122 of the Y₁Ba₂Cu₃O_{7-δ} oxide superconductor thin films 101, which was deposited on the seed thin film 102 was composed of an *a*-axis orientated Y₁Ba₂Cu₃O_{7-δ} oxide superconductor thin film and the portion 121 of the Y₁Ba₂Cu₃O_{7-δ} oxide superconductor thin films 101, which grew directly on the surface 113 of each of MgO substrate 103 was composed of a *c*-axis orientated Y₁Ba₂Cu₃O_{7-δ} oxide superconductor thin film.

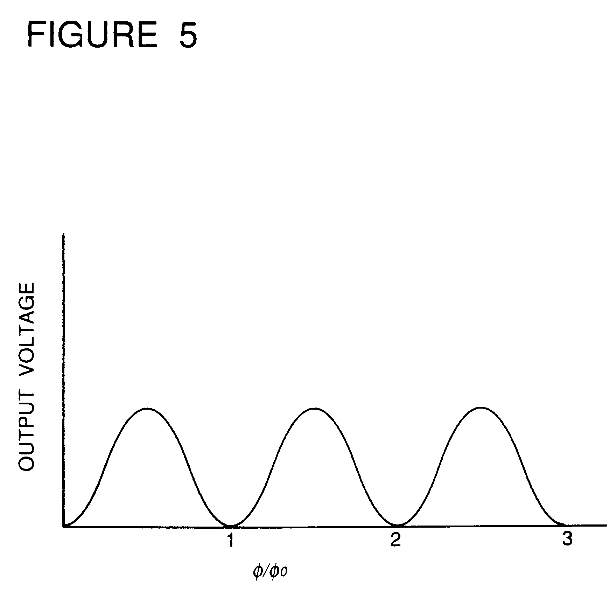

A characteristics of each of the above mentioned dc SQUIDs was measured while changing temperature. When a faint magnetic field was irradiated, the output voltage of each of the dc SQUID varied as the graph shown in Figure 5, and this variation of the output voltage was clearly observed at temperatures up to 85K. Therefore, it could be ascertained that the dc SQUIDs had excellent properties.

As explained above, if the above mentioned dc SQUID is manufactured in accordance with the above mentioned process, the limitation in the fine processing technique required for manufacturing the dc SQUID is relaxed. In addition, since the superconducting barriers are constituted of the grain boundaries, it become easy to form sharp superconducting barriers of which properties are linear up. Accordingly, it is easy to manufacture the dc SQUID with good repeatability, and the manufactured dc SQUID has a stable performance.

### Embodiment 3

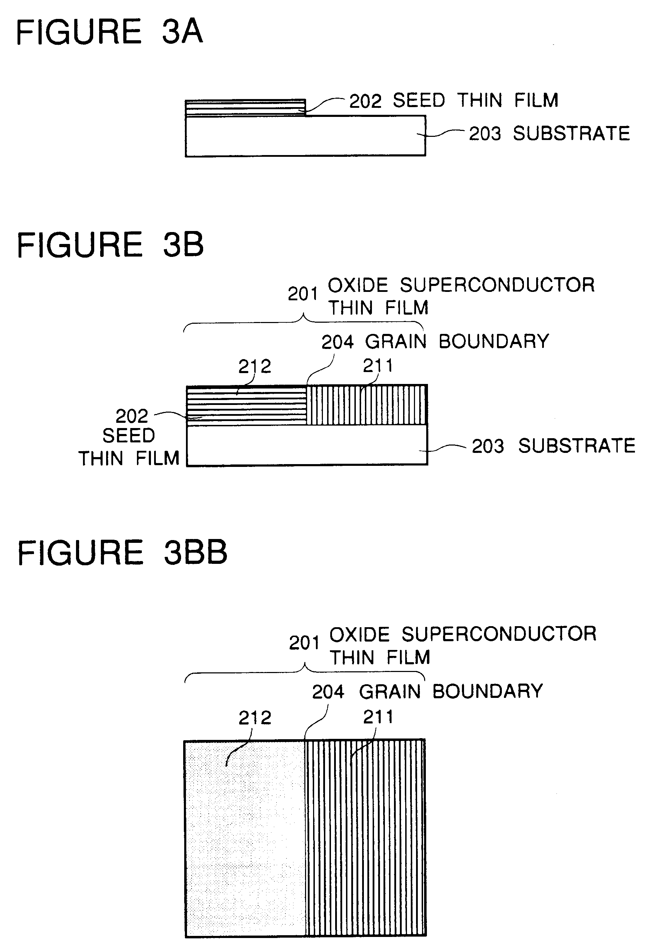

Referring to Figures 3A to 3C, the process in accordance with the present invention for manufacturing the Josephson junction device will be described.

As shown in Figure 3A, a seed thin film 202 of a *c*-axis orientated Y₁Ba₂Cu₃O_{7-δ} single crystal having a thickness of 5 nanometers was deposited on the left half of the surface of a MgO (100) single crystal substrate 203 by a sputtering process. The condition of the sputtering process was as follows;

| | | |
|---|---|---|
| Temperature of substrate | | 620°C |
| Sputtering gases | Ar | 8 sccm |
| | O₂ | 4sccm |
| Pressure | | 6.665 Pa (5x10⁻² Torr) |

The seed thin film 202 is a thin film on which a *c*-axis orientated Y₁Ba₂Cu₃O_{7-δ} thin film will grow epitaxially, even if the Y₁Ba₂Cu₃O_{7-δ} thin film is deposited under a condition under which an *a*-axis orientated Y₁Ba₂Cu₃O_{7-δ} thin film grows on the substrate. Therefore, the seed thin film 202 of *c*-axis orientated Y₁Ba₂Cu₃O_{7-δ} single crystal is not necessary to be superconducting, if it has high crystallinity. In this connection, a *c*-axis orientated Y₁Ba₂Cu₃O_{7-δ} thin film can be deposited by a sputtering process under a substrate temperature 590 to 650 °C or by a laser ablation process under a substrate temperature 630 to 700 °C.

Then, as shown in Figure 3B, a Y₁Ba₂Cu₃O_{7-δ} oxide superconductor thin film 201 having a thickness of 300 nanometers was deposited on the seed thin film 202 and the exposing right half of the surface of the MgO (100) single crystal substrate 203 by a sputtering process. The sputtering process was carried out under a condition under which an *a*-axis orientated Y₁Ba₂Cu₃O_{7-δ} oxide superconductor thin film grew on the surface of the MgO (100) single crystal substrate 203. The condition of the sputtering process was as follows;

| | | |
|---|---|---|
| Temperature of substrate | | 570°C |
| Sputtering gases | Ar | 8 sccm |
| | O₂ | 4 sccm |
| Pressure | | 6.665 Pa (5x10⁻² Torr) |

A portion 212 of the Y₁Ba₂Cu₃O_{7-δ} oxide superconductor thin film 201 on the seed thin film 202 grew epitaxially to the seed thin film 202 and the other portion 211 of the Y₁Ba₂Cu₃O_{7-δ} oxide superconductor thin film 201 on the surface of MgO substrate 203 became *a*-axis orientated. Therefore, as shown in Figure 3BB, the portion 212 of the Y₁Ba₂Cu₃O_{7-δ} oxide superconductor thin film 201, which grew on the seed thin film 202 was composed of a *c*-axis orientated Y₁Ba₂Cu₃O_{7-δ} oxide superconductor thin film and the portion 211 of the Y₁Ba₂Cu₃O_{7-δ} oxide superconductor thin film 201, which grew directly on the surface of MgO substrate 203 was composed of an *a*-axis orientated Y₁Ba₂Cu₃O_{7-δ} oxide superconductor thin film, which was the reverse of Embodiment 1. A grain boundary 204 was created on the interface between the portions 211 and 212, which was just on the edge of the seed thin film 202. The grain boundary 204 formed a weak link of a Josephson junction.

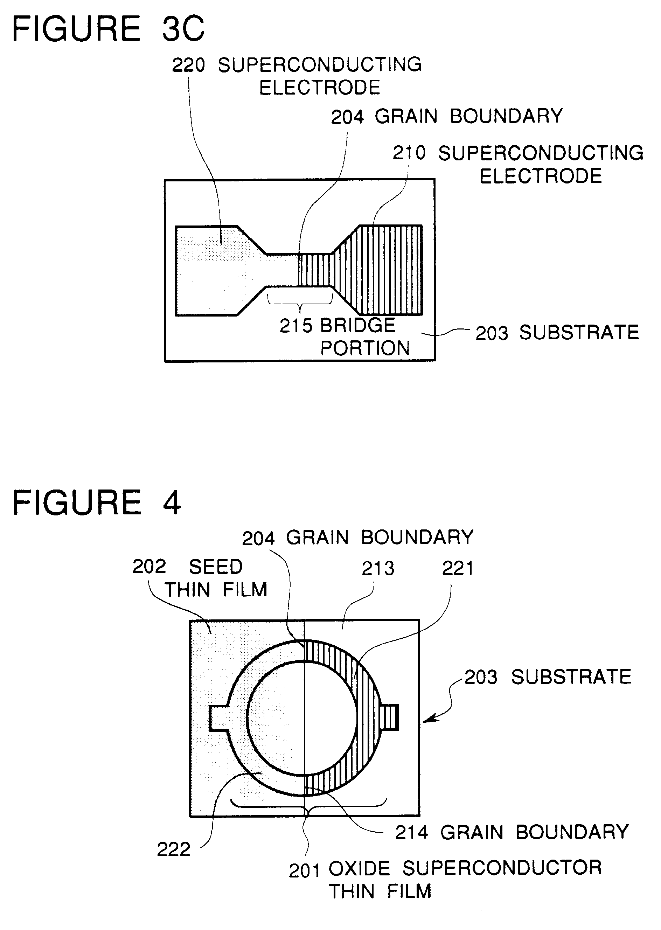

Finally, as shown in Figure 3C, the Y₁Ba₂Cu₃O_{7-δ} oxide superconductor thin film 201 was processed by a reactive ion etching process so that a bridge portion 215 having a length of 10 µm and a width of 5 µm, on the center portion of which the grain boundary 204 was positioned, was created between superconducting electrode 210 and 220 having a sufficient width as Embodiment 1. The width of the bridge portion 215 was not so narrow as that of a conventional Dayem bridge type Josephson junction device.

Thus, the Josephson junction device as shown in Figure 3C was completed. The Josephson junction device manufactured by the method in accordance with this embodiment of the present invention was constituted of an oxide superconductor thin film which had a planar surface and a bridge portion 215 having a narrow width between two superconducting electrodes 210 and 220 having a sufficient width. The lattice orientations of two superconducting electrodes 210 and 220 were different from each other so that the two superconducting electrodes 210 and 220 were weakly linked by the grain boundary 204 in the bridge portion 215, which constituted the superconducting barrier of the Josephson junction.

A current-voltage characteristics of the above mentioned Josephson junction device was measured at a temperature of 85K. When a microwave of 15 GHz and of 0.2 mW was irradiated, clear Shapiro steps of was observed at multiple voltages of 31 µV, and therefore, it could be ascertained that the Josephson junction was realized in the device.

As explained above, if the above mentioned Josephson junction device is manufactured in accordance with the above mentioned process, the limitation in the fine processing technique required for manufacturing the Josephson junction device is relaxed. In addition, since the superconducting barrier is constituted of the grain boundary, it become easy to form the superconducting barrier sharply. Accordingly, it is easy to manufacture the Josephson junction device with good repeatability, and the manufactured Josephson junction device has a stable performance.

### Embodiment 4

Referring to Figure 4, there is shown a diagrammatic plane view of another embodiment of the Josephson junction device in accordance with the present invention. The Josephson junction device shown in this embodiment is a dc SQUID.

The dc SQUID includes a MgO (100) substrate 203, a seed thin film 202 of a *c*-axis orientated Y₁Ba₂Cu₃O_{7-δ} single crystal, deposited on the left half of the surface of the MgO substrate 203 and an annular shaped Y₁Ba₂Cu₃O_{7-δ} oxide superconductor thin film 201 formed on the MgO substrate 203 and the seed thin film 202. The Y₁Ba₂Cu₃O_{7-δ} oxide superconductor thin film 201 is formed an annular ring shape which crosses an edge of the seed thin film 202 at two portions.

The portions 222 and 221 of the Y₁Ba₂Cu₃O_{7-δ} oxide superconductor thin film 201 are formed epitaxially to the seed thin film 202 and MgO substrate 103. Therefore, the portion 222 of the Y₁Ba₂Cu₃O_{7-δ} oxide superconductor thin film 201, which grew on the seed thin film 202 is composed of a *c*-axis orientated Y₁Ba₂Cu₃O_{7-δ} oxide superconductor thin film and the portion 221 of the Y₁Ba₂Cu₃O_{7-δ} oxide superconductor thin film 201, which grew directly on the surface 213 of MgO substrate 203 is composed of an *a*-axis orientated Y₁Ba₂Cu₃O_{7-δ} oxide superconductor thin film.

As the dc SQUID of Embodiment 3, grain boundaries 204 and 214 are formed on the interfaces between the portions 221 and 222 of the Y₁Ba₂Cu₃O_{7-δ} oxide superconductor thin film 201 just on the edge of the seed thin film 202. The grain boundaries 204 and 214 form weak links of a Josephson junction.

The above mentioned dc SQUID was manufactured by the following method in accordance with the present invention. At first, a seed thin film 202 of a *c*-axis orientated Y₁Ba₂Cu₃O_{7-δ} single crystal having a thickness of 5 nanometers was deposited on the left half of the surface of a MgO (100) single crystal substrate 203 by a laser ablation process. The condition of the laser ablation was as follows:

| | | |
|---|---|---|
| Temperature of substrate | | 650°C |

| O₂ atmosphere | | |
|---|---|---|
| Pressure | | 13.33 Pa (0.1 Torr) |
| Excimer laser | wave length | 1 93 nanometers |
| | energy density | 2 Joule/cm² |
| | pulse rate | 5 Hz |

Then, an annular shaped Y₁Ba₂Cu₃O_{7-δ} oxide superconductor thin film 201 having a thickness of 300 nanometers was deposited on each of the seed thin film 202 and the exposing right half of the surface 213 of each of the MgO (100) substrate 203 by a laser ablation process in which patterned silicone plate was used as a mask. The condition of the laser ablation was as follows:

| | | |
|---|---|---|
| Temperature of substrate | | 600°C |

| O₂ atmosphere | | |
|---|---|---|
| Pressure | | 13.33 Pa (0.1 Torr) |
| Excimer laser | wave length | 193 nanometers |
| | energy density | 2 Joule/cm² |
| | pulse rate | 5 Hz |

As mentioned above, the portion 222 of each of the Y₁Ba₂Cu₃O_{7-δ} oxide superconductor thin film 201, which was deposited on the seed thin film 202 was composed of a *c*-axis orientated Y₁Ba₂Cu₃O_{7-δ} oxide superconductor thin film and the portion 221 of the Y₁Ba₂Cu₃O_{7-δ} oxide superconductor thin film 201, which grew directly on the surface 213 of MgO substrate 203 was composed of an *a*-axis orientated Y₁Ba₂Cu₃O_{7-δ} oxide superconductor thin film.

A characteristics of the above mentioned dc SQUIDs was measured while changing temperature. When a faint magnetic field was irradiated, the output voltage of each of the dc SQUID varied as the graph shown in Figure 5, and this variation of the output voltage was clearly observed at temperatures up to 85K. Therefore, it could be ascertained that the dc SQUID had excellent properties.

As explained above, if the above mentioned dc SQUID is manufactured in accordance with the above mentioned process, the limitation in the fine processing technique required for manufacturing the dc SQUID is relaxed. In addition, since the superconducting barriers are constituted of the grain boundaries, it become easy to form sharp superconducting barriers of which properties are linear up. Accordingly, it is easy to manufacture the dc SQUID with good repeatability, and the manufactured dc SQUID has a stable performance.

The invention has thus been shown and described with reference to the specific embodiments. However, it should be noted that the present invention is in no way limited to the details of the illustrated structures but converts and modifications may be made within the scope of the appended claims.

## Claims

1. A Josephson junction device comprising a substrate (103;203) and an oxide superconductor thin film (101;201) formed on a principal surface of the substrate, characterized in that the principal surface of the substrate is uniform and planar and the oxide superconductor thin film (101;201) comprises two portions constituted of single crystals of Y₁Ba₂Cu₃O_{7-δ} superconductor, one (112; 120;122;212;220;222) of which is composed of a-axis orientated single crystal of Y₁Ba₂Cu₃O_{7-δ} superconductor and the other (111;110;121;211;210;221) of which is composed of c-axis orientated single crystal of Y₁Ba₂Cu₃O_{7-δ} superconductor, each portion being formed on the principal surface of the substrate, and a grain boundary (104;204) between said two portions, which constitutes a weak link of the Josephson junction.

2. A Josephson junction device claimed in claim 1, characterized in that the a-axis and c-axis orientated portions of the oxide superconductor thin film are connected by two apart portions separated from each other, each of the apart portions includes the grain boundary (104; 104,114;204;204,214) which constitutes the weak link of the Josephson junction.

3. A Josephson junction device claimed in claim 2, characterized in that the oxide superconductor thin film is formed in an annular shape (101;201) which includes the apart portions each of which includes the grain boundary (104,114;204,214) which constitutes the weak link of Josephson junction, so that the Josephson junction device constitutes a dc SQUID.

4. A Josephson junction device claimed in anyone of claims 1 to 3, characterized in that a portion (115: 215) of the oxide superconductor thin film, in which the grain boundary (104;204) is formed, has a narrower width than other portions.

5. A Josephson junction device claimed in claim 4, characterized in that the narrow portion (115;215) of the oxide superconductor thin film has a width of 1.5 to 15 µm and a length of 5 to 50 µm.

6. A Josephson junction device claimed in anyone of claims 1 to 5, characterized in that the substrate (103;203) is formed of a material selected from the group consisting of a MgO(100) substrate, a SrTiO3 (110) substrate and an yttrium stabilized zirconia (YSZ) substrate.

7. A process of manufacturing a Josephson junction device comprising a substrate (103;203) and an oxide superconductor thin film (101;201) formed on a principal surface of the substrate, characterized in that the process comprises the steps of forming on a portion of a principal surface of a substrate an oxide thin film which is composed of an a-axis orientated Y₁Ba₂Cu₃O_{7-δ} superconductor crystal or a c-axis orientated Y₁Ba₂Cu₃O_{7-δ} superconductor crystal (102;202), and forming an oxide Y₁Ba₂Cu₃O_{7-δ} superconductor thin film (101;201) on the oxide thin film and the exposing principal surface of the substrate under a condition suitable for growing, on the substrate, an oxide superconductor thin film of a c-axis orientated single crystal in the case of an a-axis orientated oxide thin film, and of an a-axis orientated single crystal in the case of a c-axis orientated oxide thin film, so that the oxide superconductor thin film has two portions one (112;120;122;212;220;222) of which is composed of an a-axis orientated Y₁Ba₂Cu₃O_{7-δ} superconductor crystal and the other (111;110;121;211;210;221) of which is composed of c-axis orientated Y₁Ba₂Cu₃O_{7-δ} superconductor crystal so as to form a grain boundary (104;204), between the two portions of the oxide superconductor thin film, which constitutes a weak link of the Josephson junction.

8. A process claimed in claim 7, characterized in that the process further includes the step of narrowing a portion (115;215) of the oxide superconductor thin film, which connects the a-axis orientated and c-axis orientated portions of the oxide superconductor thin film by a reactive ion etching process.

9. A process claimed in claim 8, characterized in that the oxide superconductor thin film is formed by using a silicone plate mask so that the oxide superconductor thin film is shaped so as to include two apart portions crossing the step portion formed of the oxide thin film, each of which includes the grain boundary (104,114; 204, 214) which constitutes the weak link of the Josephson junction.

10. A process claimed in claim 9, characterized in that the oxide superconductor thin film is shaped into an annular shape (101;201) which includes the two apart portions, each of which includes the grain boundary (104, 114;204,214) which constitutes the weak link of the Josephson junction.

## Patentansprüche

1. Josephson-Übergangseinrichtung, die aufweist ein Substrat (103; 203) und einen oxidischen Supraleiter-Dünnfilm (101; 201), gebildet auf einer prinzipiellen Oberfläche des Substrats, gekennzeichnet dadurch, daß die prinzipielle Oberfläche des Substrats gleichförmig und eben ist und der oxidische Supraleiter-Dünnfilm (101; 201) zwei Bereiche, die aus Einkristallen aus einem Y₁Ba₂Cu₃O_{7-δ} Supraleiter gebildet sind, wobei einer (112; 120; 122; 212; 220; 222) davon aus einem a-Achsen orientierten Einkristall eines Y₁Ba₂Cu₃O_{7-δ} Supraleiters zusammengesetzt ist und der andere (111; 110; 121; 211; 210; 221) davon aus einem c-Achsen orientierten Einkristall eines Y₁Ba₂Cu₃O_{7-δ} Supraleiters zusammengesetzt ist, wobei jeder Bereich auf der prinzipiellen Oberfläche des Substrats gebildet ist und eine Korngrenze (104; 204) zwischen den zwei Bereichen, die eine schwache Verbindung des Josephson-Übergangs bildet, aufweist.

2. Josephson-Übergangseinrichtung nach Anspruch 1, dadurch gekennzeichnet, daß ein a-Achsen und ein c-Achsen orientierter Bereich des oxidischen Supraleiter-Dünnfilms durch zwei voneinander entfernte Bereiche, getrennt voneinander, verbunden sind, wobei jeder der voneinander getrennten Bereiche die Korngrenze (104, 114; 204; 204, 214) umfaßt, die die schwache Verbindung des Josephson-Übergangs bildet, wobei jeder Bereich auf der prinzipiellen Oberfläche des Substrats gebildet ist.

3. Josephson-Übergangseinrichtung nach Anspruch 2, dadurch gekennzeichnet, daß der oxidische Supraleiter-Dünnfilm in einer ringförmigen Form (101; 201) gebildet ist, der die voneinander entfernten Bereiche umfaßt, wobei jeder davon die Korngrenze (104, 114; 204, 214) umfaßt, die die schwache Verbindung des Josephson-Übergangs bildet, so daß die Josephson-Übergangseinrichtung eine dc SQUID bildet.

4. Josephson-Übergangseinrichtung nach einem der Ansprüche 1 bis 3, dadurch gekennzeichnet, daß ein Bereich (115; 215) des oxidischen Supraleiter-Dünnfilms, in dem die Korngrenze (104; 204) gebildet ist, eine schmalere Breite als andere Bereiche besitzt.

5. Josephson-Übergangseinrichtung nach Anspruch 4, dadurch gekennzeichnet, daß der schmale Bereich (115; 215) des oxidischen Supraleiter-Dünnfilms eine Breite von 1,5 bis 15 µm und eine Länge von 5 bis 50 µm besitzt.

6. Josephson-Übergangseinrichtung nach einem der Ansprüche 1 bis 5, dadurch gekennzeichnet, daß das Substrat (103; 203) aus einem Material gebildet ist, das aus der Gruppe ausgewählt ist, die aus einem MgO-(100)-Substrat, einem SrTiO₃-(110)-Substrat und einem mit Yttrium stabilisierten Zirkonoxid-(YSZ)-Substrat besteht.

7. Verfahren zum Herstellen einer Josephson-Übergangseinrichtung, die ein Substrat (103; 203) und einen oxidischen Supraleiter-Dünnfilm (101; 201), gebildet auf einer prinzipiellen Oberfläche des Substrats, aufweist, dadurch gekennzeichnet, daß das Verfahren die Schritte eines Bildens auf einem Bereich einer prinzipiellen Oberfläche eines Substrats eines oxidischen Dünnfilms, der aus einem a-Achsen orientierten Y₁Ba₂Cu₃O_{7-δ} Supraleiter-Kristall oder einem c-Achsen orientierten Y₁Ba₂Cu₃O_{7-δ} Supraleiter-Kristall (102; 202) zusammengesetzt ist, und Bilden eines Y₁Ba₂Cu₃O_{7-δ} Supraleiter-Dünnfilms (101; 201) auf dem oxidischen Dünnfilm und Aussetzen der prinzipiellen Oberfläche des Subtrats einer Bedingung umfaßt, die für ein Anwachsen auf dem Substrat eines oxidischen Supraleiter-Dünnfilms eines c-Achsen orientierten Einkristalls geeignet ist, in dem Fall eines a-Achsen orientierten, oxidischen Dünnfilms, und eines a-Achsen orientierten Einkristalls in dem Fall eines c-Achsen orientierten, oxidischen Dünnfilms, so daß der oxidische Supraleiter-Dünnfilm zwei Bereiche besitzt, wobei einer (112; 120; 122; 212; 220; 222) davon aus einem a-Achsen orientierten Y₁Ba₂Cu₃O_{7-δ} Supraleiter-Kristall zusammengesetzt ist und der andere (111; 110; 121; 211; 210; 221) davon aus einem c-Achsen orientierten Y₁Ba₂Cu₃O_{7-δ} Supraleiter-Kristall zusammengesetzt ist, um so eine Korngrenze (104; 204) zwischen den zwei Bereichen des oxidischen Supraleiter-Dünnfilms zu bilden, die eine schwache Verbindung des Josephson-Übergangs bildet.

8. Verfahren nach Anspruch 7, dadurch gekennzeichnet, daß das Verfahren weiterhin den Schritt eines Verengens eines Bereichs (115; 215) des oxidischen Supraleiter-Dünnfilms umfaßt, der den a-Achsen orientierten und den c-Achsen orientierten Bereich des oxidischen Supraleiter-Dünnfilms verbindet, durch einen reaktive Ionenätzvorgang.

9. Verfahren nach Anspruch 8, dadurch gekennzeichnet, daß der oxidische Supraleiter-Dünnfilm unter Verwendung einer Silikonplattenmaske gebildet ist, so daß der oxidische Supraleiter-Dünnfilm so geformt ist, um zwei voneinander entfernte Bereiche, die den Stufenbereich kreuzen, gebildet auf dem oxidischen Dünnfilm, zu umfassen, wobei jeder davon die Korngrenze (104, 114; 204, 214) umfaßt, die die schwache Verbindung des Josephson-Übergangs bildet.

10. Verfahren nach Anspruch 9, dadurch gekennzeichnet, daß der oxidische Supraleiter-Dünnfilm zu einer ringförmigen Form (101; 201) geformt ist, die die zwei voneinander entfernten Bereiche umfaßt, wobei jeder davon die Korngrenze (104, 114; 204, 214) umfaßt, die die schwache Verbindung des Josephson-Übergangs bildet.

## Revendications

1. Dispositif à jonction Josephson comprenant un substrat (103 ; 203) et une couche mince d'oxyde supraconducteur (101 ; 201) formée sur une surface principale du substrat, caractérisé en ce que la surface principale du substrat est uniforme et plane et la couche mince d'oxyde supraconducteur (101 ; 201) comprend deux régions constituées de monocristaux de supraconducteur Y₁Ba₂Cu₃O_{7-δ}, dont l'une (112 ; 120 ; 122 ; 212 ; 220 ; 222) est constituée d'un monocristal de supraconducteur Y₁Ba₂Cu₃O_{7-δ} orienté suivant l'axe a et dont l'autre (111 ; 110 ; 121 ; 211 ; 210 ; 221) est constituée d' un monocristal de supraconducteur Y₁Ba₂Cu₃O_{7-δ} orienté suivant l'axe c, chaque région étant formée sur la surface principale du substrat, et un joint de grains (104 ; 204) entre les deux régions, qui constitue une liaison faible de la jonction Josephson.

2. Dispositif à jonction Josephson **suivant** la revendication 1, caractérisé en ce que les régions orientées suivant l axe a et suivant l'axe c de la couche mince d'oxyde supraconducteur sont reliées par deux régions distantes séparées l'une de l'autre, chacune des régions distantes comprend le joint de grains (104 ; 104, 114 ; 204 ; 204, 214) qui constitue la liaison faible de la jonction Josephson, chaque région étant formée sur la surface principale du substrat.

3. Dispositif à jonction Josephson **suivant** la revendication 2, caractérisé en ce que la couche mince d'oxyde supraconducteur est formée en une configuration annulaire (101 ; 201) qui comprend les régions distantes dont chacune comprend le joint de grains (104, 114 ; 204, 214) qui constitue la liaison faible de la jonction Josephson, en sorte que le dispositif à jonction Josephson constitue un SQUID DC.

4. Dispositif à jonction Josephson **suivant** l'une quelconque des revendications 1 à 3, caractérisé en ce qu'une région (115 ; 215) de la couche mince d'oxyde supraconducteur, dans laquelle est formé le joint de grains (104 ; 204), a une largeur plus étroite que les autres régions.

5. Dispositif à jonction Josephson **suivant** la revendication 4, caractérisé en ce que la région étroite (115 ; 215) de la couche mince d'oxyde supraconducteur a une largeur de 1,5 à 15 µm et une longueur de 5 à 50 µm.

6. Dispositif à jonction Josephson **suivant** l'une quelconque des revendications 1 à 5, caractérise en ce que le substrat (103 ; 203) est constitué d'un matériau choisi dans le groupe formé par un substrat de MgO (100), un substrat de SrTiO₃ (110) et un substrat de zircone stabilisée par l'yttrium (YSZ).

7. Procédé de fabrication d'un dispositif à jonction Josephson comprenant un substrat (103 ; 203) et une couche mince d'oxyde supraconducteur (101 ; 201) formée sur une surface principale du substrat, caractérisé en ce que le procédé comprend les étapes consistant à former sur une région d'une surface principale d'un substrat une couche mince d'oxyde qui est constituée d'un cristal de supraconducteur Y₁Ba₂Cu₃O_{7-δ} orienté suivant l'axe a ou d'un cristal de supraconducteur Y₁Ba₂Cu₃O_{7-δ} orienté suivant l'axe c (102 ; 202), et à former une couche mince d'oxyde supraconducteur Y₁Ba₂Cu₃O_{7-δ} (101 ; 201) sur la couche mince d'oxyde et la surface principale exposée du substrat dans un état convenant pour faire croître, sur le substrat, une couche mince d'oxyde supraconducteur constituée d'un monocristal orienté suivant l'axe c dans le cas d'une couche mince d'oxyde orientée suivant l'axe a, et d'un monocristal orienté suivant l'axe a dans le cas d'une couche mince d'oxyde orientée suivant l'axe c, de sorte que la couche mince d'oxyde supraconducteur comporte deux régions dont l'une (112 ; 120 ; 122 ; 212 ; 220 ; 222) est constituée d'un cristal de supraconducteur Y₁Ba₂Cu₃O_{7-δ} orienté suivant l'axe a et dont l'autre (111 ; 110 ; 121 ; 211 ; 210 ; 221) est constituée d'un cristal de supraconducteur Y₁Ba₂Cu₃O_{7-δ} orienté suivant l'axe c, en formant ainsi un joint de grains (104 ; 204) entre les deux régions de la couche mince d'oxyde supraconducteur, qui constitue une liaison faible de la jonction Josephson.

8. Procédé **suivant** la revendication 7, caractérisé en ce que le procédé comprend de plus l'étape consistant à rétrécir une région (115 ; 215) de la couche mince d'oxyde supraconducteur, qui relie les régions orientée suivant l'axe a et orientée suivant l'axe c de la couche mince d'oxyde supraconducteur, par un procédé de gravure ionique réactive.

9. Procédé **suivant** la revendication 8, caractérisé en ce que la couche mince d'oxyde supraconducteur est formée en utilisant un masque constitué d'une plaque de silicone, en sorte que la couche mince d'oxyde supraconducteur soit configurée de manière à comprendre deux régions distantes croisant la région de gradin formée de la couche mince d'oxyde, dont chacune comprend le joint de grains (104, 114 ; 204, 214) qui constitue la liaison faible de la jonction Josephson.

10. Procédé **suivant** la revendication 9, caractérisé en ce que la couche mince d'oxyde supraconducteur est formée en une configuration annulaire (101 ; 201) qui comprend les deux régions distantes dont chacune comprend le joint de grains (104, 114 ; 204, 214) qui constitue la liaison faible de la jonction Josephson.
